# EUROPEAN PATENT APPLICATION

(11) **EP 4 110 026 A1**
(43) Date of publication of application: **28.12.2022**
(21) Application number: 22167582.0
(22) Date of filing: 11.04.2022
(51) Int. Cl.: H05K 7/20

(54) **HEAT DISSIPATION DEVICE FOR LED LIGHT STRIP OF TELEVISION**

(30) Priority: 25.06.2021 CN 202121438477 U
(71) Applicant: Guangdong Envicool Technology Co., Ltd., Sanjiao Town, Zhongshan Guangdong 528400 (CN)
(72) Inventor: WANG, Ye, Zhongshan, 528400 (CN); SU, Hongmeng, Zhongshan, 528400 (CN); ZHANG, Jing, Zhongshan, 528400 (CN)
(74) Representative: Potter Clarkson

(57) **Abstract**

A heat dissipation device for an LED light strip of a television is provided, including a heat dissipation substrate and a heat dissipation cover plate. The heat dissipation substrate includes a mounting plate and a heat dissipation bottom plate connected to the mounting plate, the mounting plate is provided with a clamping opening for mounting the LED light strip. The heat dissipation cover plate is fixed on the heat dissipation bottom plate, and a cavity configured to be filled with a refrigerant working medium is defined between the heat dissipation cover plate and the heat dissipation bottom plate. A liquid injection port is provided on the heat dissipation bottom plate or the heat dissipation cover plate, which is in communication with the cavity and is used for filling the cavity with the refrigerant working medium.

## Description

### FIELD

The present application relates to the technical field of electronic heat dissipation, and in particular to a heat dissipation device for an LED light strip of a television.

### BACKGROUND

With the development of science and technology, the definition requirements of televisions are continuously increased, and the power of luminous LED strips in televisions also increases. The heat dissipation requirements of the televisions cannot be met by using an extruded aluminum plate as a heat dissipation cover plate to conduct the heat of the LED light strips the heat dissipation cover plate in a thermally conductive manner, and then transfer the heat to the television housing via convection.

In a situation that a metal heat dissipation cover plate in the form of an inflated plate is adopted, through the phase change diffusion of the medium, heat is rapidly dissipated to the whole heat dissipation cover plate, the temperature of the heat dissipation cover plate is uniform, the technology is mature, easy to manufacture and low in cost. However, since the LED light strip is arranged above a bending portion of the heat dissipation device, and the cavity of the metal heat dissipation cover plate is limited to an inside of the main body portion, the heat is conducted from the light strip to the bending portion of the heat dissipation device, and then from the bending portion to the main body portion, and the heat is dissipated through the phase change of the main body portion. In this case, the transfer path is long, the transfer heat resistance is large, and the heat dissipation effect is poor.

Therefore, a technical problem to be addressed by those skilled in the art is to improve the heat dissipation performance.

### SUMMARY

An object of the present application is to provide a heat dissipation device for an LED light strip of a television, to improve the heat dissipation performance.

To achieve the above object, the following solutions are provided according to the present application.

A heat dissipation device for an LED light strip of a television, including a heat dissipation substrate and a heat dissipation cover plate; where
the heat dissipation substrate includes a mounting plate and a heat dissipation bottom plate connected to the mounting plate, the mounting plate is provided with a clamping opening configured for mounting the LED light strip; and
the heat dissipation cover plate is fixed on the heat dissipation bottom plate, and a cavity configured to be filled with a refrigerant working medium is defined between the heat dissipation cover plate and the heat dissipation bottom plate; and
a liquid injection port is provided on the heat dissipation bottom plate or the heat dissipation cover plate, the liquid injection port is in communication with the cavity and is used for filling the cavity with the refrigerant working medium.

In an embodiment, the heat dissipation cover plate or the heat dissipation bottom plate is provided with multiple support members which are spaced apart, and the multiple support members protrude from the heat dissipation cover plate or the heat dissipation bottom plate, to allow the heat dissipation cover plate and the heat dissipation bottom plate to support each other when the heat dissipation cover plate and the heat dissipation bottom plate are fixedly connected, to form the cavity.

In an embodiment, the heat dissipation cover plate is fixedly welded to the heat dissipation bottom plate.

In an embodiment, the heat dissipation substrate is a copper heat dissipation substrate, an aluminum heat dissipation substrate or an alloy heat dissipation substrate.

In an embodiment, the heat dissipation bottom plate is connected to a side of the mounting plate, and the heat dissipation bottom plate is perpendicular to the mounting plate.

In an embodiment, the mounting plate, the clamping opening and the heat dissipation bottom plate are integrally formed.

In an embodiment, the number of the clamping opening is multiple.

In an embodiment, the multiple clamping openings are arranged along a length direction of the mounting plate.

By adopting the heat dissipation device for the LED light strip of the television of the present application, the light strip is mounted on the clamping opening, and the cavity is filled with the refrigerant working medium through the liquid injection port. In case that the LED light strip is working, the heat generated is first transferred to the heat dissipation substrate, and then transferred via the heat dissipation bottom plate to a lower portion of the cavity defined by the heat dissipation bottom plate and the heat dissipation cover plate. Since the refrigerant working medium inside the cavity is in a saturated state, when the liquid refrigerant working medium inside the cavity is heated, a boiling process occurs inside the cavity and the liquid refrigerant working medium becomes a gaseous refrigerant working medium. Meanwhile, under the action of gravity, the gaseous working medium moves upwards and releases heat to an upper portion of the cavity through phase change of condensation. The condensed liquid working medium flows, under the action of gravity, along the inner surface of the cavity to the lower portion of the cavity, thus realizing the circulation of the refrigerant working medium. Because the heat transfer is performed in the cavity through phase change and diffusion movement of the working medium, the temperature difference between the upper and lower portions of the cavity is small, and the fin efficiency is high, which can greatly improve the heat dissipation efficiency of the heat dissipation device, and thereby ensuring that the temperature of the heat source is in the ideal working range. As the heat dissipation bottom plate of the present application extends from the mounting plate in the direction away from the heat dissipation substrate, the heat resistance along the path between the strip and the cavity is reduced, which improves the heat dissipation effect.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is an exploded schematic view showing the structure of a heat dissipation device for an LED strip of a television according to an embodiment of the present application; and
FIG. 2 is a perspective schematic view showing the structure of the heat dissipation device according to the embodiment of the present application.

Reference numerals in the drawings:

| | | | |
|---|---|---|---|
| 100 | heat dissipation substrate, | 200 | heat dissipation cover plate, |
| 300 | liquid injection port, | 400 | support member, |
| 101 | clamping opening, | 102 | heat dissipation bottom plate, |
| 103 | mounting plate. | | |

### DETAILED DESCRIPTION OF THE EMBODIMENTS

In order to improve the heat dissipation performance of the heat dissipation device of electronic components, there are mainly three existing solutions. The first solution is to improve the material composition of the heat dissipation cover plate, , to improve the thermal conductivity of the heat dissipation cover plate through the combination and stacking of different material layers, so as to enhance the heat exchange efficiency of the heat dissipation device. The second solution is to improve the structure of the heat dissipation cover plate, to increase the convection heat transfer effect of the heat dissipation cover plate by adding fins, providing openings, etc., so as to enhance the heat transfer efficiency of the heat dissipation device. The third solution is to replace the original heat dissipation cover plate with an inflated plate, and mount the LED strip at a bending portion at a lower side of the lower layered aluminum plate.

In order to meet the heat dissipation effect, make up for the decrease in heat dissipation performance caused by the uneven temperature of the parts of the heat dissipation cover plate, the main solution is to improve the heat dissipation structure of the heat dissipation cover plate, increase the fins, to improve the thermal conductivity or convection heat exchange effect of the heat dissipation cover plate, so as to enhance the heat exchange efficiency of the heat dissipation device. As a result, the size and weight of the heat dissipation cover plate increase, which does not meet the requirements of light weight and convenience. Besides, regarding improvement of the material composition, it is costly, and the obtained heat dissipation cover plate is fragile, which also greatly increases the cost.

An object of the present application is to provide a heat dissipation device for an LED light strip of a television, to improve the heat dissipation performance.

In order to make those skilled in the art better understand technical solutions of the present application, the present application will be described in detail hereinafter in conjunction with the drawings and specific embodiments.

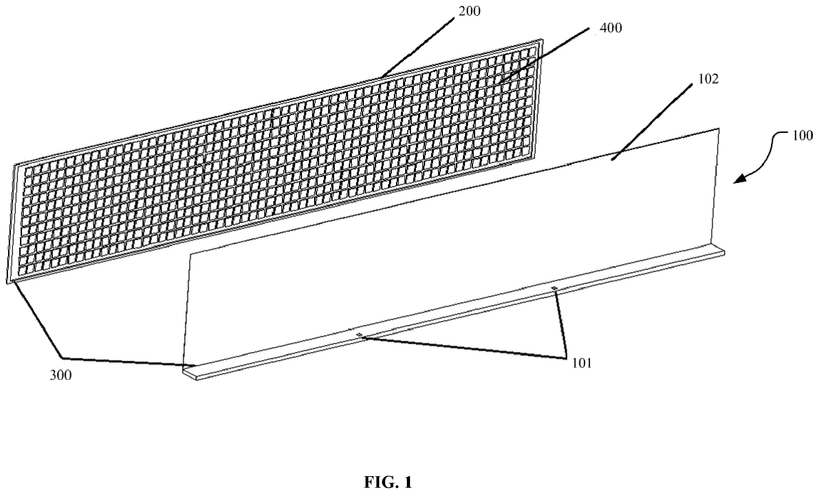

Referring to FIG. 1 to FIG. 2, a heat dissipation device for an LED light strip of a television is provided according to the present application, which includes a heat dissipation substrate 100 and a heat dissipation cover plate 200, the heat dissipation substrate 100 includes a mounting plate 103 and a heat dissipation bottom plate 102 connected to the mounting plate 103, the mounting plate 103 is provided with a clamping opening 101 for mounting the LED light strip; the heat dissipation cover plate 200 is fixed on the heat dissipation bottom plate 102, and a cavity configured to be filled with a refrigerant working medium is defined between the heat dissipation cover plate 200 and the heat dissipation bottom plate 102; a liquid injection port 300 is provided on the heat dissipation bottom plate 102 or the heat dissipation cover plate 200, the liquid injection port 300 is in communication with the cavity and is used for filling the cavity with the refrigerant working medium.

By adopting the heat dissipation device for the LED light strip of the television of the present application, the strip is mounted on the clamping opening, and the cavity is filled with the refrigerant working medium through the liquid injection port 300. In case that the LED light strip is working, the heat generated is first transferred to the heat dissipation substrate 100, and then transferred via the heat dissipation substrate 100 and the heat dissipation bottom plate 102 to a lower portion of the cavity defined by the heat dissipation bottom plate 102 and the heat dissipation cover plate 200. Since the refrigerant working medium inside the cavity is in a saturated state, when the liquid refrigerant working medium inside the cavity is heated, a boiling process occurs inside the cavity and the liquid refrigerant working medium becomes a gaseous refrigerant working medium. Meanwhile, under the action of gravity, the gaseous working medium moves upwards and releases heat to an upper portion of the cavity through phase change of condensation. The condensed liquid working medium flows, under the action of gravity, along the inner surface of the cavity to the lower portion of the cavity, thus realizing the circulation of the refrigerant working medium. Because the heat transfer is performed in the cavity through phase change and diffusion movement of the working medium, the temperature difference between the upper and lower portions of the cavity is small, and the fin efficiency is high, which can greatly improve the heat dissipation efficiency of the heat dissipation device, and thereby ensuring that the temperature of the heat source is in the ideal working range. As the heat dissipation bottom plate of the present application extends from the mounting plate in the direction away from the heat dissipation substrate, the heat resistance along the path between the strip and the cavity is reduced, which improves the heat dissipation effect.

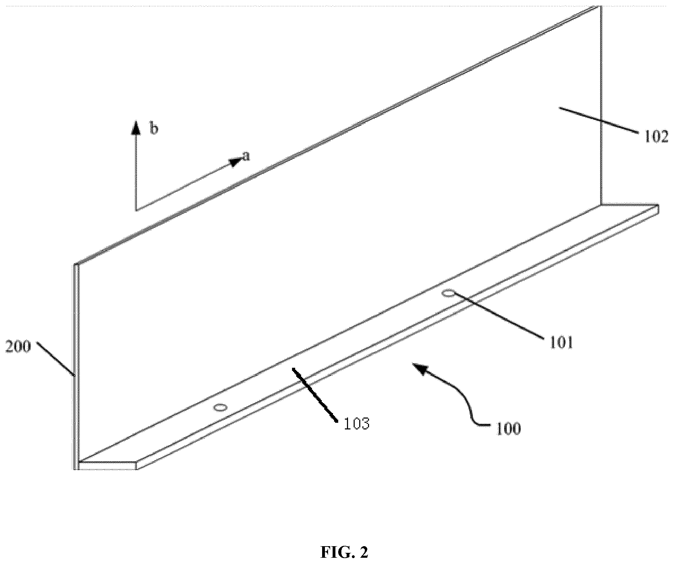

It should be noted that, a length direction "a" in the present application is a direction in which the light strip extends, and a height direction "b" in the present application is perpendicular to the length direction "a", which are shown by arrows in FIG. 2. The heat dissipation cover plate 200 and the heat dissipation substrate 100 are arranged to extend in the length direction "a", to realize the heat dissipation of the entire light strip. The heat dissipation bottom plate 102 extends in the height direction "b", so that a certain distance is maintained for heat exchange when the refrigerant working medium inside the cavity undergoes a phase change.

In order to improve the temperature uniformity, multiple support members 400 spaced apart are also arranged in the cavity defined by the heat dissipation bottom plate 102 and the heat dissipation cover plate 200, so that when the heat dissipation cover plate 200 and the heat dissipation bottom plate 102 are fixedly connected, they supports each other, to form the cavity. The support members 400 accelerate the phase change process of the refrigerant working medium through siphon effect or capillary effect. In an embodiment, the support members 400 are embodied as a grid-like structure, so that the refrigerant working medium in the cavity may be uniformly diffused to the surroundings, thereby improving the temperature uniformity.

The heat dissipation cover plate 200 is directly and fixedly welded on the heat dissipation bottom plate 102, or is fixed on the heat dissipation bottom plate 102 through a sealing member and a connecting member, so that the cavity forms a relatively closed space.

In order to improve the heat dissipation efficiency of the entire heat dissipation device, the heat dissipation cover plate in the embodiment of the present application is made of materials with good heat conductivity. For example, copper, aluminum or aluminum alloy, preferably, aluminum or aluminum alloy may be adopted, because aluminum and aluminum alloy not only have good thermal conductivity, but also have lighter weight, which is consistent with the development trend of light weight of the television. The material of the heat dissipation substrate 100 is the same as the material of the heat dissipation cover plate 200, for example, the heat dissipation substrate 100 may be made of materials with good thermal conductivity such as copper, aluminum or alloy.

During processing, the heat dissipation cover plate 200 is welded to the heat dissipation bottom plate 102, and then evacuation is performed through the liquid injection port 300, and then the refrigerant working medium is filled into the cavity through the liquid injection port 300, and finally a sealing process is performed.

The heat dissipation substrate 100 is a cylindrical structure or a prism structure, or other structures that may extend along a certain direction. Preferably, the heat dissipation bottom plate 102 is connected to a side of the mounting plate 103, and the heat dissipation bottom plate 102 is perpendicular to the mounting plate 103. That is, the heat dissipation substrate 100 is a cuboid structure, and one side face of the heat dissipation substrate 100 is the mounting plate.

As the heat dissipation substrate 100 is provided with the clamping opening 101 and the heat dissipation bottom plate 102, after the heat dissipation substrate 100 is processed, the clamping opening 101 and the heat dissipation bottom plate 102 are processed by cutting, milling, forging, die-casting and other processes; or the heat dissipation substrate 100 is integrally formed with the clamping opening 101 and the heat dissipation bottom plate 102 provided on the heat dissipation substrate.

The number of clamping opening 101 is one or more, any structure that can realize the installation of the light strip on the heat dissipation substrate 100 can be regarded as the clamping opening 101. Preferably, the number of clamping opening 101 is multiple.

In a case that multiple clamping openings 101 are provided, the multiple clamping openings 101 are arranged along the length direction "a" or multiple clamping openings 101 are arranged in a concentrated manner.

It should be noted that, in this specification, the terms "first", "second", "third", "fourth" and the like (if present) in the description, claims and drawings are used for distinguishing between similar parts and are not intended to describe a specific sequence or precedence order. Besides, terms "include", "comprise" or any other variations are intended to cover non-exclusive "include", thus a process, a method, an object or a device including a series of factors not only include the listed factors, but also include other factors not explicitly listed, or also include inherent factors of the process, the method, the object or the device. Without more limitations, a factor defined by a sentence "include one..." does not exclude a case that there is another same factor in the process, the method, the object or the device including the described factor.

The above embodiments in this specification are described in a progressive manner. Each of the embodiments is mainly focused on describing its differences from other embodiments, and references may be made among these embodiments with respect to the same or similar portions among these embodiments.

Based on the above description of the disclosed embodiments, those skilled in the art are capable of carrying out or using the present application. It is obvious for those skilled in the art to make many modifications to these embodiments. The general principle defined herein may be applied to other embodiments without departing from the scope of the present application. Therefore, the present application is not limited to the embodiments illustrated herein, but should be defined by the broadest scope consistent with the principle and novel features disclosed herein.

## Claims

1. A heat dissipation device for an LED light strip of a television, comprising:
a heat dissipation substrate and a heat dissipation cover plate; wherein
the heat dissipation substrate comprises a mounting plate and a heat dissipation bottom plate connected to the mounting plate, the mounting plate is provided with a clamping opening configured for mounting the LED light strip;
the heat dissipation cover plate is fixed on the heat dissipation bottom plate, and a cavity configured to be filled with a refrigerant working medium is defined between the heat dissipation cover plate and the heat dissipation bottom plate; and
a liquid injection port is provided on the heat dissipation bottom plate or the heat dissipation cover plate, the liquid injection port is in communication with the cavity and is used for filling the cavity with the refrigerant working medium.

2. The heat dissipation device according to claim 1, wherein the heat dissipation cover plate or the heat dissipation bottom plate is provided with a plurality of support members which are spaced apart, and the plurality of support members protrude from the heat dissipation cover plate or the heat dissipation bottom plate, to allow the heat dissipation cover plate and the heat dissipation bottom plate to support each other when the heat dissipation cover plate and the heat dissipation bottom plate are fixedly connected, to form the cavity.

3. The heat dissipation device according to claim 1, wherein the heat dissipation cover plate is fixedly welded to the heat dissipation bottom plate.

4. The heat dissipation device according to claim 1, wherein a material of the heat dissipation cover plate is the same as a material of the heat dissipation substrate.

5. The heat dissipation device according to claim 1, wherein the heat dissipation substrate is a copper heat dissipation substrate, an aluminum heat dissipation substrate or an alloy heat dissipation substrate.

6. The heat dissipation device according to claim 1, wherein the heat dissipation bottom plate is connected to a side of the mounting plate, and the heat dissipation bottom plate is perpendicular to the mounting plate.

7. The heat dissipation device according to claim 1, wherein the mounting plate, the clamping opening and the heat dissipation bottom plate are integrally formed.

8. The heat dissipation device according to claim 1, wherein the number of the clamping opening is plural.

9. The heat dissipation device according to claim 8, wherein the plurality of clamping openings are arranged along a length direction of the mounting plate.
